# EUROPÄISCHE PATENTSCHRIFT

(11) **EP 1 935 222 B1**
(45) Veröffentlichungstag und Bekanntmachung des Hinweises auf die Patenterteilung: **24.11.2010**
(21) Anmeldenummer: 06793717.7
(22) Anmeldetag: 21.09.2006
(51) Int. Cl.: H05K 9/00

(54) **ELEKTRISCHE VORRICHTUNG**
ELECTRICAL DEVICE
DISPOSITIF ELECTRIQUE

(30) Priorität: 10.10.2005 DE 102005048416
(43) Veröffentlichungstag der Anmeldung: 25.06.2008
(73) Patentinhaber: Continental Automotive GmbH, 30165 Hannover (DE)
(72) Erfinder: KROHN, Thomas, 65824 Schwalbach (DE); ULLRICH, Horst, 61137 Schoeneck (DE)
(86) Internationale Anmeldenummer: PCT/EP2006/066596
(87) Internationale Veröffentlichungsnummer: WO 2007/042383

(56) Entgegenhaltungen:
- WO-A-2004/008823
- DE-U1- 9 319 079
- US-A- 5 014 160
- US-A- 5 160 807
- US-A1- 2004 256 128

## Beschreibung

Die Erfindung bezieht sich auf eine elektrische Vorrichtung mit einem elektronische Bauteile tragenden Trägersubstrat, das eine Leiterbahnstruktur zur Verbindung der elektronischen Bauteile trägt und auf dem ein die Leiterbahnstruktur und die Bauteile umschließendes elektrisch leitendes Abschirmelement angeordnet ist, wobei das Abschirmelement aus einem mit seinem Öffnungsrandbereich auf einer ersten Oberfläche des Trägersubstrats aufliegenden ersten topfartigen Abschirmteil und einem mit seinem Öffnungsrandbereich auf einer zweiten Oberfläche des Trägersubstrats aufliegenden zweiten topfartigen Abschirmteil besteht und die Abschirmteile auf dem Trägersubstrat befestigbar sind, wobei das Trägersubstrat durchgehende zweite Ausnehmungen aufweist, durch die erste Arme des ersten Abschirmteils und/oder zweite Arme des zweiten Abschirmteils hindurchragen, die mit ihren freien Endbereichen aus den zweiten Ausnehmungen herausragen und das zweite Abschirmteil und/oder das erste Abschirmteil kontaktieren, wobei das erste Abschirmteil mit einem festen elektrischen Potential verbundenen ist.

Elektronische und elektrische Geräte erzeugen elektromagnetische Felder, die Fehlfunktionen oder Ausfälle von anderen elektronischen Geräten bewirken können.

Elektronische Schaltungen oder Schaltungsteile müssen den gesetzlichen EMV-Vorschriften genügen. Häufig ergeben sich noch schärfere Anforderungen durch den Einsatzbereich des Gerätes z. B. als Sicherheitsteil in einem Kraftfahrzeug.

Um die Funktion von elektronischen Schaltungen unter den geforderten EMV-Anforderungen zu gewährleisten, müssen sie mit einem elektrisch leitenden Metallgehäuse abgeschirmt werden. Das Gehäuse muss dabei möglichst komplett geschlossen sein. Um eine ausreichende Abschirmwirkung zu erhalten, müssen mit steigenden Frequenzen der elektromagnetischen Strahlung die zulässigen maximalen Gehäuseöffnungen immer kleiner werden.

Auch kann es erforderlich sein, zwei oder mehrere Schaltungsteile auf dem selben Schaltungsträger voneinander abzuschirmen.

Bei einer elektrischen Vorrichtung der eingangs genannten Art ist es bekannt, dass mindestens ein Befestigungsansatz vorhanden ist, der zur Befestigung des Abschirmteils an dem Trägersubstrat in eine Ausnehmung des Trägersubstrats einrastbar ist.

Aus der US-A-5 160 807 ist eine elektrische Vorrichtung der eingangs genannten Art bekannt.

Zur Kontaktierung des ersten Abschirmteils mit einem festen elektrischen Potential sind zwischen dem ersten Abschirmteil sowie zwischen dem zweiten Abschirmteil und dem Trägersubstrat leitende Hülsen angeordnet, durch deren Hülsenbohrungen und eine Bohrung im Trägersubstrat eine Schraube hindurchgeführt ist, die sich mit ihrem Schraubenkopf an dem ersten Abschirmteil abstützt und die mit ihrem freien Ende in eine sich an dem zweiten Abschirmteil abstützende Mutter eingeschraubt ist. Diese Verbindung dient gleichzeitig zur Befestigung der Abschirmteile an dem Trägersubstrat.

Aus der WO 2004/008823 A ist eine elektrische Vorrichtung bekannt, bei der ein einziges Abschirmteil auf einer einzigen Oberfläche eines Trägersubstrats angeordnet ist.

Aus der US 2004/256128 A1 ist eine elektrische Vorrichtung bekannt, bei der beidseitig eines Trägersubstrats Abschirmteile angeordnet sind. Im Trägersubstrat sind Ausnehmungen vorhanden, durch die Rastarme des ersten Abschirmteils hindurchragen, die mit an ihren freien Enden ausgebildeten Nocken in entsprechende Ausnehmungen des zweiten Abschirmteils einrasten.

Aufgabe der Erfindung ist es eine elektrische Vorrichtung der eingangs genannten Art zu schaffen, die gut insbesondere auch gegen hochfrequente elektromagnetische Felder und Magnetfelder abgeschirmt wird.

Diese Aufgabe wird erfindungsgemäß dadurch gelöst, dass das erste topfartige Abschirmteil mit seinem Öffnungsrandbereich auf einer mit einem festen elektrischen Potential verbundenen Kontaktfläche der ersten Oberfläche des Trägersubstrats aufliegt, die Abschirmteile mittels in erste Ausnehmungen des Trägersubstrats eingreifende Befestigungsansätze auf dem Trägersubstrat befestigbar sind und die ersten Arme erste Federarme sowie die zweiten Arme zweite Federarme sind.

Durch die Federarme können die elektronischen Bauteile und die Leiterbahnstrukturen zumindest weitgehend vollständig mit Metall umgeben werden, da dies auch im Bereich des Trägersubstrats erfolgt.

Gleichzeitig wird eine einfache Montage sowie eine Demontage zur Inspektion und Reparatur der elektronischen Bauteile ermöglicht.

Durch das gegenseitige Kontaktieren der Abschirmteile durch die Federarme werden auch die üblichen Kraftfahrzeug-Anforderungen bezüglich der Temperatur und Vibrationsbelastungen erfüllt.

Die elektronischen Bauteile sowie die Leiterbahnstruktur sind durch das weitgehend komplette Umgeben mit Metall sowohl gegen hochfrequente elektromagnetische Felder im GHz-Bereich wie z.B. eines Mobiltelefons als auch gegen Magnetfelder im kHz-Bereich wie z.B. von Lautsprecherkabeln gut abgeschirmt.

Eine Montage der Abschirmelemente erfolgt erst nach dem Löten, einer Lötstelleninspektion, einem Reparieren, Programmieren und Testen der elektronischen Bauteile und der Leiterbahnstruktur.

Es sind zur Abschirmung nur die beiden Abschirmteile erforderlich. Weitere Teile z.B. zur Befestigung wie Nieten oder Schrauben sind nicht erforderlich, so daß die Lagerhalterung für die Abschirmkomponenten vereinfacht ist.

Sind die ersten Federarme des ersten Abschirmteils mit ihrem freien Ende federnd in Anlage an dem zweiten Abschirmteil und/oder die zweiten Federarme des zweiten Abschirmteils mit ihrem freien Ende an dem ersten Abschirmteil federnd in Anlage, so erfolgt dadurch gleichzeitig eine direkte elektrische Verbindung zwischen den beiden Abschirmteilen.

Eine gute Dichte der Abschirmung erfolgt dadurch, daß mehrere erste Federarme und/oder mehrere zweite Federarme mit einem einer Federarmbreite entsprechenden Abstand nebeneinanderliegend angeordnet sind, wobei die zweiten Ausnehmungen Schlitze sind, durch die mehrere erste Federarme und/oder zweite Federarme nebeneinanderliegend hindurchragen.

Die Abschirmung ist im Bereich der Federarme nahezu lückenlos, wenn dabei erste und zweite Federarme nebeneinanderliegend alternierend durch die Schlitze hindurchragen.

Eine einfache Montage ohne zusätzliche Befestigungselemente ist dadurch möglich, daß die Befestigungsansätze die ersten Ausnehmungen durchragende Blecharme sind, deren aus den ersten Ausnehmungen herausragende freie Enden verformbar sind.

Es ist aber auch möglich, dass anstatt der Blecharme separate Nieten, Nieten aus Durchzügen aus dem Material der Abschirmteile, Biege- oder Verschränkungslaschenvarianten oder Laschen als Rasthaken verwendet werden.

Eine feste Verbindung zwischen den beiden Abschirmteilen und damit auch eine Sicherung auf dem Trägersubstrat wird dadurch erreicht, dass das erste Abschirmteil und/oder das zweite Abschirmteil an seinem umlaufenden Öffnungsrand in eine zur Ebene des Trägersubstrats parallele Ebene von dem Innenraum des ersten Abschirmteils weggerichtet abgebogene Laschen mit Durchgangsöffnungen besitzt, die etwa gleichen Querschnitt wie die Blecharme besitzen und durch die die freien Enden der Blecharme hindurchragen und verformbar sind.

Zur definierten Abstützung der Abschirmteile auf dem Trägersubstrat besitzt vorzugsweise das erste Abschirmteil und/oder das zweite Abschirmteil mehrere an seinem umlaufenden Öffnungsrand verteilt angeordnete, in eine zur Ebene des Trägersubstrats annähernd parallele Ebene von dem Innenraum des ersten Abschirmteils weggerichtet abgebogene Auflageschultern.

In den Bereichen, in denen Leiterbahnen aus dem abgeschirmten Bereich herausgeführt werden sollen, können das erste Abschirmteil und/oder das zweite Abschirmteil an seinem umlaufenden Öffnungsrand eine oder mehrere in eine zur Ebene des Trägersubstrats annähernd parallele Ebene von dem Innenraum des ersten und/oder zweiten Abschirmteils weggerichtet abgebogene Kontaktlaschen besitzt, die federnd an der oder den Kontaktflächen des Trägersubstrats anlegbar sind.

Dabei sind vorzugsweise die Kontaktlaschen in den Bereichen zwischen den Federarmen und/oder den Blecharmen angeordnet. Zur Vervollkommnung des metallischen Umschließens können auf der ersten Oberfläche und der zweiten Oberfläche des Trägersubstrats einander gegenüberliegend die Kontaktlaschen angeordnet und mittels Durchkontaktierungen im Trägersubstrat elektrisch leitend miteinander verbunden sein, wobei im Bereich jeder Kontaktlasche eine Durchkontaktierung angeordnet sein kann.

Um das Umschließen möglichst dicht auszuführen, können die Durchkontaktierungen mit geringem Abstand zueinander angeordnet sein.

Vorzugsweise ist das Trägersubstrat eine Mehrlagenleiterplatte.

Dabei können eine oder zwei äußere Leitebenen der Mehrlagenleiterplatte die Kontaktflächen bilden und mit dem festen elektrischen Potential verbunden sein und eine oder mehrere innere Leitebenen der Mehrlagenleiterplatte signalführende Leiterbahnen sein.

Dies ermöglicht es auf einfache Weise auch Leiterbahnen vom Inneren der Abschirmteile nach außen zu führen.

Auf das Trägersubstrat können mehrere Leiterbahnstrukturen zur Verbindung elektronischer Bauteile angeordnet sein, wobei jede Leiterbahnstruktur von einem elektrisch leitenden Abschirmelement umschlossen ist.

Dabei können die auf einer Seite des Trägersubstrats angeordneten Abschirmteile einteilig mit einer Trennwand ausgebildet sein.

Zur elektrischen Verbindung der beiden Leiterbahnstrukturen sind diese vorzugsweise über eine innere Leitebene der Mehrlagenleiterplatte leitend miteinander verbunden.

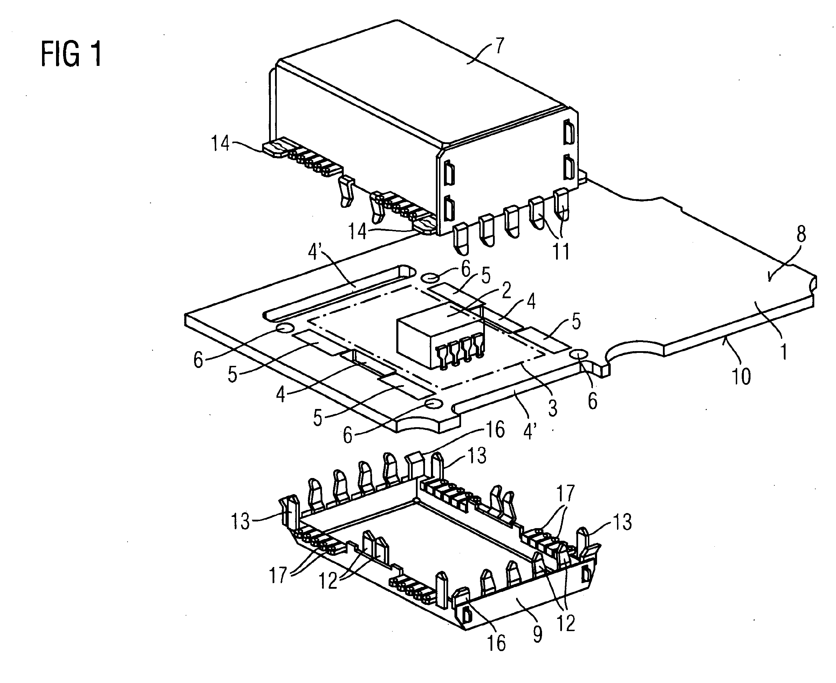

Ein Ausführungsbeispiel der Erfindung ist in der Zeichnung dargestellt und wird im folgenden näher beschrieben. Es zeigen
- Figur 1: eine elektrische Vorrichtung in perspektivischer Explosionsdarstellung

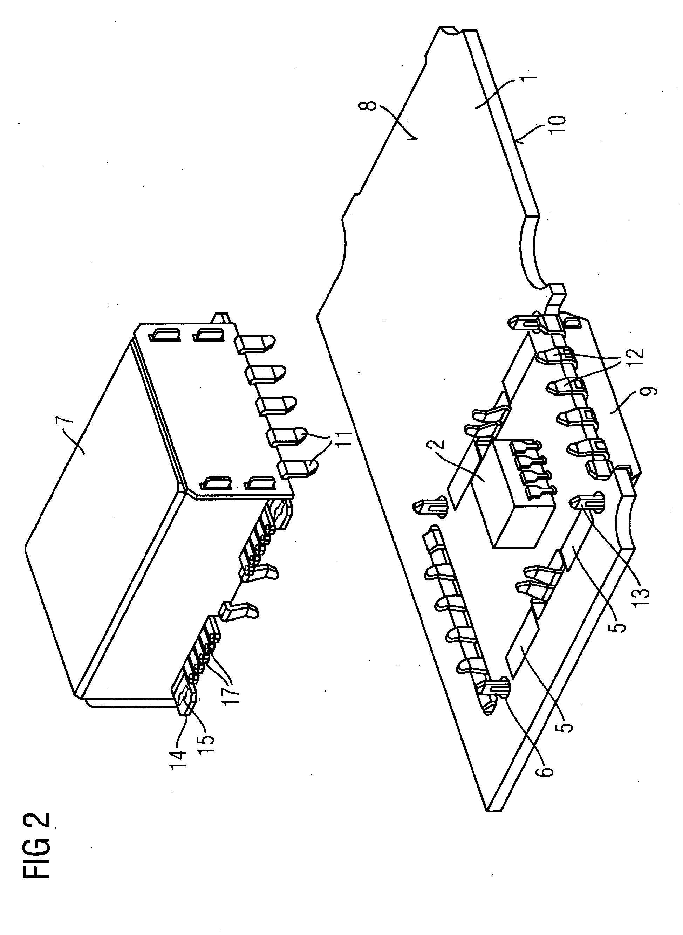

- Figur 2: eine perspektivische Darstellung der elektrischen Vorrichtung nach Figur 1 mit ab- gehobenem ersten Abschirmteil
- Figur 3: eine perspektivische Darstellung der elektrischen Vorrichtung nach Figur 1 im Zusammenbauzustand

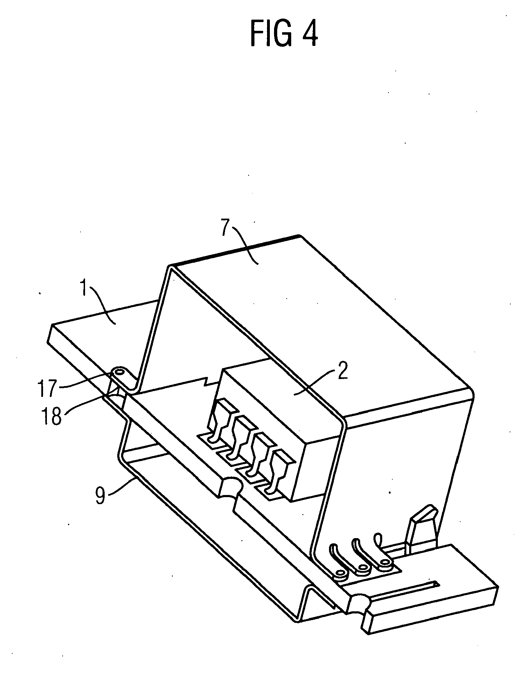

- Figur 4: die elektrische Vorrichtung nach Figur 1 in einer perspektivischen Seitenansicht.

Die in den Figuren dargestellte elektrische Vorrichtung weist ein als Leiterplatte ausgebildetes Trägersubstrat 1 auf, auf dem eine nicht dargestellte Leiterbahnstruktur sowie durch die Leiterbahnstruktur verbindbare elektronische Bauteile 2 angeordnet sind.

Die Leiterbahnstruktur und die elektronischen Bauteile 2 befinden sich innerhalb eines rechteckigen abzuschirmenden Bereichs 3, der von einer strichpunktierten Linie umschlossen dargestellt ist.

Entlang der langen Seiten des Rechtecks des abzuschirmenden Bereichs 3 befindet sich im Trägersubstrat 1 mittig ein durchgehender Schlitz 4, an den sich beidseitig auf das Trägersubstrat 1 streifenartig aufgebrachte Kontaktflächen 5 anschließen.

In den Eckbereichen außerhalb des abzuschirmenden Bereichs 3 sind anschließend an die Kontaktfläche 5 durchgehend erste Ausnehmungen 6 im Trägersubstrat 1 ausgebildet.

Entlang der gesamten kurzen Seiten erstrecken sich außerhalb des abzuschirmenden Bereichs 3 ebenfalls durchgehende Schlitze 4' im Trägersubstrat 1.

Ein erstes topfartiges Abschirmteil 1 ist mit seinem Öffnungsrandbereich so auf eine erste Oberfläche 8 des Trägersubstrats 1 aufsetzbar, dass der abzuschirmende Bereich 3 abgedeckt ist.

In gleicher Weise ist ein zweites topfartiges Abschirmteil 9 mit seinem Öffnungsrandbereich so auf eine zweite Oberfläche 10 des Trägersubstrats 1 aufsetzbar, dass der abzuschirmende Bereich 3 von der Unterseite her abgedeckt ist.

Die Umlaufkonturen der Öffnungsrandbereiche beider Abschirmteile 7 und 9 sind dabei gleich.

Die Abschirmteile 7 und 9 sind Stanz-/Biegeteile aus Blech.

Entlang der kurzen Seiten des ersten Abschirmteils 7 sind eine Reihe zum Trägersubstrat 1 gerichtete erste Federarme 11 einteilig mit dem ersten Abschirmteil 2 ausgebildet, die einen einer Federarmbreite entsprechenden Abstand zueinander besitzen und bei auf das Trägersubstrat aufgesetztem ersten Abschirmteil 7 durch die Schlitze 4' hindurchragen.

Ebenfalls entlang der kurzen Seiten des zweiten Abschirmteils 9 sind eine Reihe zum Trägersubstrat 1 gerichtete zweite Federarme 12 einteilig mit dem zweiten Abschirmteil 9 ausgebildet, die einen einer Federarmbreite entsprechenden Abstand zueinander besitzen und bei auf das Trägersubstrat 1 aufgesetztem zweiten Abschirmteil 9 durch die Schlitze 4' hindurchragen.

Auch dabei hintergreifen die aus den Schlitzen 4' herausragenden freien Enden der zweiten Federarme 12 federnd das Trägersubstrat 1.

Dadurch, dass bei auf das Trägersubstrat 1 aufgesetztem ersten Abschirmteil 7 und zweitem Abschirmteil 9 die ersten Federarme 11 und die zweiten Federarme 12 nebeneinanderliegend alternierend durch die Schlitze 4' ragen, verschließen sie gegenseitig die Abstände zwischen den Federarmen 11 und 12, so dass im Bereich der Schlitze 4' eine von dem ersten Abschirmteil 7 zum zweiten Abschirmteil 9 durchgehende Abschirmung erreicht wird.

Da dabei die freien Enden der ersten Federarme 11 an einer Wand des zweiten Abschirmteils 9 und die freien Enden der zweiten Federarme 12 an einer Wand des ersten Abschirmteils 7 federnd in Anlage gelangen, sind die beiden Abschirmteile 7 und 9 leitend miteinander verbunden.

In gleicher Weise sind an den Längsseiten der Abschirmteile 7 und 9 erste Federarme 11 und zweite Federarme 12 ausgebildet, die durch die Schlitze 4 hindurchragen und dort eine durchgehende Abschirmung bilden.

Entsprechend der ersten Ausnehmungen 6 sind an dem zweiten Abschirmteil 9 Blecharme 13 einteilig ausgebildet, die zum Trägersubstrat 1 gerichtet sind und bei auf das Trägersubstrat 1 aufgesetztem zweiten Abschirmteil 9 durch die ersten Ausnehmungen 6 hindurchragen.
Entsprechend der ersten Ausnehmungen 6 sind an dem ersten Abschirmteil 7 von dem Innenraum des ersten Abschirmteils 7 in eine zur Ebene des Trägersubstrats 1 weggerichtet abgebogene Laschen 14 einteilig mit dem ersten Abschirmteil 7 ausgebildet.

Diese Laschen 14 besitzen Durchgangsöffnungen 15, die etwa gleichen Querschnitt wie die Blecharme 13 besitzen und durch die die freien Enden der Blecharme 13 bei auf das Trägersubstrat 1 aufgesetzten ersten und zweiten Abschirmteilen 7 und 9 hindurchragen.

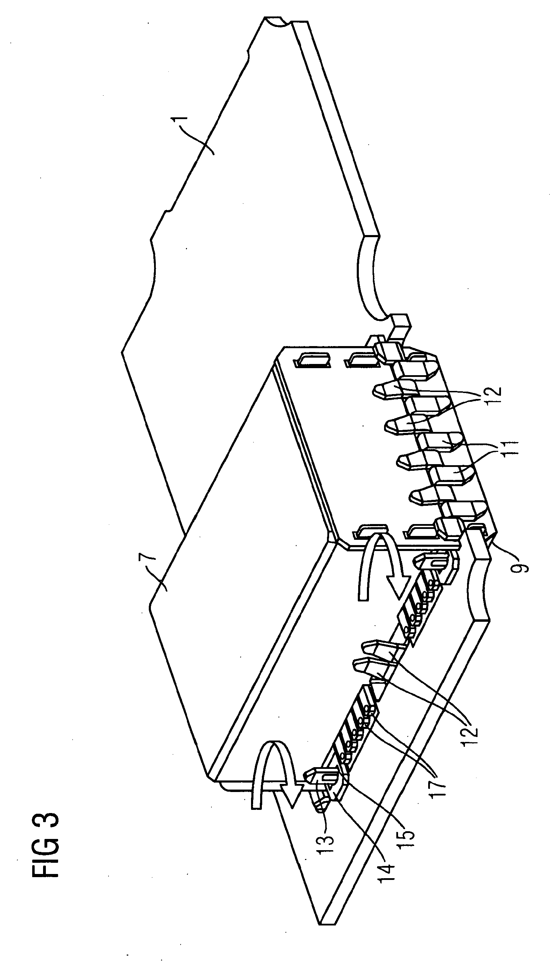

Durch Verdrehen der freien Enden der Blecharme 13 (siehe Pfeile in Figur 3) erfolgt eine Sicherung der Abschirmteile 7 und 9 in ihrer Einbaulage.

In dieser Einbaulage gelangen in den Eckbereichen des zweiten Abschirmteils 9 einteilig mit dem zweiten Abschirmteil 9 ausgebildete und von dem Innenraum des zweiten Abschirmteils 9 weggerichtet abgebogene Auflageschultern 16 ebenfalls an dem Trägersubstrat 1 zu Auflage.

In den Bereichen der Längsseiten von erstem Abschirmteil 7 und zweiten Abschirmteil 9 sind zwischen den ersten Federarmen 11 bzw. den zweiten Federarmen 12 und den Laschen 14 bzw. den Blecharmen 13 einteilig mit dem ersten Abschirmteil 7 und dem zweiten Abschirmteil 9 Reihen von Kontaktlaschen 17 ausgebildet.

Die Kontaktlaschen 17 erstrecken sich in einer zur Ebene des Trägersubstrats 1 annähernd parallelen Ebene von dem Innenraum des ersten und zweiten Abschirmteil 7 und 9 weggerichtet und liegen bei auf das Trägersubstrat 1 aufgesetztem ersten und zweiten Abschirmteil 7 und 9 auf den Kontaktflächen 5 federnd auf.

Die jeweils einander gegenüberliegenden Kontaktlaschen 17 sind mittels im Trägersubstrat 1 angeordneter Durchkontaktierungen 18 im Bereich jeder Kontaktfläche 17 elektrisch leitend miteinander verbunden.

## Patentansprüche

1. Elektrische Vorrichtung mit einem elektronische Bauteile tragenden Trägersubstrat, das eine Leiterbahnstruktur zur Verbindung der elektronischen Bauteile trägt und auf dem ein die Leiterbahnstruktur und die Bauteile umschließendes elektrisch leitendes Abschirmelement angeordnet ist, wobei das Abschirmelement aus einem mit seinem Öffnungsrandbereich auf einer ersten Oberfläche des Trägersubstrats aufliegenden ersten topfartigen Abschirmteil und einem mit seinem Öffnungsrandbereich auf einer zweiten Oberfläche des Trägersubstrats aufliegenden zweiten topfartigen Abschirmteil besteht und die Abschirmteile auf dem Trägersubstrat befestigbar sind, wobei das Trägersubstrat durchgehende zweite Ausnehmungen aufweist, durch die erste Arme des ersten Abschirmteils und/oder zweite Arme des zweiten Abschirmteils hindurchragen, die mit ihren freien Endbereichen aus den zweiten Ausnehmungen herausragen und das zweite Abschirmteil und/oder das erste Abschirmteil kontaktieren, wobei das erste Abschirmteil mit einem festen elektrischen Potential verbundenen ist, **dadurch gekennzeichnet, dass** das erste topfartige Abschirmteil (7) mit seinem Öffnungsrandbereich auf einer mit einem festen elektrischen Potential verbundenen Kontaktfläche (5) der ersten Oberfläche (8) des Trägersubstrats (1) aufliegt, die Abschirmteile (7, 9) mittels in erste Ausnehmungen (6) des Trägersubstrats (1) eingreifende Befestigungsansätze auf dem Trägersubstrat (1) befestigbar sind und die ersten Arme erste Federarme (11) sowie die zweiten Arme zweite Federarme (12) sind.

2. Elektrische Vorrichtung nach Anspruch 1, **dadurch gekennzeichnet, dass** die ersten Federarme (11) des ersten Abschirmteils (7) mit ihrem freien Ende federnd in Anlage an dem zweiten Abschirmteil (9) und/oder die zweiten Federarme (12) des zweiten Abschirmteils (9) mit ihrem freien Ende an dem ersten Abschirmteil (7) federnd in Anlage sind.

3. Elektrische Vorrichtung nach einem der vorhergehenden Ansprüche, **dadurch gekennzeichnet, dass** mehrere erste Federarme (11) und/oder mehrere zweite Federarme (12) mit einem einer Federarmbreite entsprechenden Abstand nebeneinanderliegend angeordnet sind.

4. Elektrische Vorrichtung nach einem der vorhergehenden Ansprüche, **dadurch gekennzeichnet, dass** die zweiten Ausnehmungen Schlitze (4, 4') sind, durch die mehrere erste Federarme (11) und/oder zweite Federarme (12) nebeneinanderliegend hindurchragen.

5. Elektrische Vorrichtung nach Anspruch 4, **dadurch gekennzeichnet, dass** erste und zweite Federarme (11, 12) nebeneinanderliegend alternierend durch die Schlitze (4, 4') hindurchragen.

6. Elektrische Vorrichtung nach einem der vorhergehenden Ansprüche, **dadurch gekennzeichnet, dass** die Befestigungsansätze die ersten Ausnehmungen (6) durchragende Blecharme (13) sind, deren aus den ersten Ausnehmungen (6) herausragende freie Enden verformbar sind.

7. Elektrische Vorrichtung nach Anspruch 6, **dadurch gekennzeichnet, dass** das erste Abschirmteil (7) und/oder das zweite Abschirmteil an seinem umlaufenden Öffnungsrand in eine zur Ebene des Trägersubstrats (1) parallele Ebene von dem Innenraum des ersten Abschirmteils (7) weggerichtet abgebogene Laschen (14) mit Durchgangsöffnungen (15) besitzt, die etwa gleichen Querschnitt wie die Blecharme (13) besitzen und durch die die freien Enden der Blecharme (13) hindurchragen und verformbar sind.

8. Elektrische Vorrichtung nach einem der vorhergehenden Ansprüche, **dadurch gekennzeichnet, dass** das erste Abschirmteil und/oder das zweite Abschirmteil (9) mehrere an seinem umlaufenden Öffnungsrand verteilt angeordnete, in eine zur Ebene des Trägersubstrats (1) annähernd parallele Ebene von dem Innenraum des ersten und/oder zweiten Abschirmteils (9) weggerichtet abgebogene Auflageschultern (16) besitzt.

9. Elektrische Vorrichtung nach einem der vorhergehenden Ansprüche, **dadurch gekennzeichnet, dass** das erste Abschirmteil (7) und/oder das zweite Abschirmteil (9) an seinem umlaufenden Öffnungsrand eine oder mehrere in eine zur Ebene des Trägersubstrats (1) annähernd parallele Ebene von dem Innenraum des ersten und/oder zweiten Abschirmteils (7, 9) weggerichtet abgebogene Kontaktlaschen (17) besitzt, die federnd an der oder den Kontaktflächen (5) des Trägersubstrats (1) anlegbar sind.

10. Elektrische Vorrichtung nach einem der vorhergehenden Ansprüche, **dadurch gekennzeichnet, dass** die Kontaktlaschen (17) in den Bereichen zwischen den Federarmen (11, 12) und/oder den Blecharmen (13) angeordnet sind.

11. Elektrische Vorrichtung nach einem der vorhergehenden Ansprüche, **dadurch gekennzeichnet, daß** auf der ersten Oberfläche (8) und der zweiten Oberfläche (10) des Trägersubstrats (1) einander gegenüberliegend die Kontaktlaschen (17) angeordnet und mittels Durchkontaktierungen (18) im Trägersubstrat (1) elektrisch leitend miteinander verbunden sind.

12. Elektrische Vorrichtung nach einem der Ansprüche 10 und 11, **dadurch gekennzeichnet, dass** im Bereich jeder Kontaktlasche (17) eine Durchkontaktierung (18) angeordnet ist.

13. Elektrische Vorrichtung nach einem der Ansprüche 10 bis 12, **dadurch gekennzeichnet, dass** die Durchkontaktierungen (18) mit geringem Abstand zueinander angeordnet sind.

14. Elektrische Vorrichtung nach einem der vorhergehenden Ansprüche, **dadurch gekennzeichnet , dass** das Trägersubstrat eine Mehrlagenleiterplatte ist.

15. Elektrische Vorrichtung nach Anspruch 14, **dadurch gekennzeichnet, dass** eine oder zwei äußere Leitebenen der Mehrlagenleiterplatte die Kontaktflächen bilden und mit dem festen elektrischen Potential verbunden sind.

16. Elektrische Vorrichtung nach einem der Ansprüche 14 und 15, **dadurch gekennzeichnet, dass** eine oder mehrere innere Leitebenen der Mehrlagenleiterplatte signalführende Leiterbahnen sind.

17. Elektrische Vorrichtung nach einem der vorhergehenden Ansprüche, **dadurch gekennzeichnet , dass** auf dem Trägersubstrat mehrere Leiterbahnstrukturen zur Verbindung elektronischer Bauteile angeordnet sind, wobei jede Leiterbahnstruktur von einem elektrisch leitenden Abschirmelement umschlossen ist.

18. Elektrische Vorrichtung nach Anspruch 17, **dadurch gekennzeichnet, dass** die Leiterbahnstrukturen über eine innere Leitebene der Mehrlagenleiterplatte leitend miteinander verbunden sind.

## Claims

1. Electrical device comprising a carrier substrate which carries electronic components and carries a conductor track structure for connecting the electronic components and on which is arranged an electrically conductive shielding element enclosing the conductor track structure and the components, wherein the shielding element comprises a first pot-like shielding part, which bears with its opening edge region on a first surface of the carrier substrate, and a second pot-like shielding part, which bears with its opening edge region on a second surface of the carrier substrate, and the shielding parts can be fixed on the carrier substrate, wherein the carrier substrate has continuous second cutouts, through which protrude first arms of the first shielding part and/or second arms of the second shielding part, which protrude with their free end regions from the second cutouts and make contact with the second shielding part and/or the first shielding part, wherein the first shielding part is connected to a fixed electrical potential, **characterized in that** the first pot-like shielding part (7) bears with its opening edge region on a contact area (5) of the first surface (8) of the carrier substrate (1), said contact area being connected to a fixed electrical potential, the shielding parts (7, 9) can be fixed on the carrier substrate (1) by means of fixing attachments which engage into first cutouts (6) of the carrier substrate (1) and the first arms are first spring arms (11) and the second arms are second spring arms (12).

2. Electrical device according to claim 1, **characterized in that** the first spring arms (11) of the first shielding part (7) rest resiliently with their free end against the second shielding part (9) and/or the second spring arms (12) of the second shielding part (9) rest resiliently with their free end against the first shielding part (7).

3. Electrical device according to any of the preceding claims, **characterized in that** a plurality of first spring arms (11) and/or a plurality of second spring arms (12) are arranged adjacent to one another at a distance corresponding to a spring arm width.

4. Electrical device according to any of the preceding claims, **characterized in that** the second cutouts are slots (4, 4') through which a plurality of first spring arms (11) and/or second spring arms (12) protrude adjacent to one another.

5. Electrical device according to Claim 4, **characterized in that** first and second spring arms (11, 12) protrude through the slots (4, 4') alternately adjacent to one another.

6. Electrical device according to any of the preceding claims, **characterized in that** the fixing attachments are sheet-metal arms (13) which protrude through the first cutouts (6) and whose free ends protruding from the first cutouts (6) are deformable.

7. Electrical device according to Claim 6, **characterized in that** the first shielding part (7) and/or the second shielding part has on its peripheral opening edge lugs (14) - bent in a manner directed away from the interior of the first shielding part (7) into a plane parallel to the plane of the carrier substrate (1) - having through openings (15) which have approximately the same cross section as the sheet-metal arms (13) and through which the free ends of the sheet-metal arms (13) protrude and are deformable.

8. Electrical device according to any of the preceding claims, **characterized in that** the first shielding part and/or the second shielding part (9) has a plurality of bearing shoulders (16) which are arranged in a manner distributed on its peripheral opening edge and are bent in a manner directed away from the interior of the first and/or second shielding part (9) into a plane approximately parallel to the plane of the carrier substrate (1).

9. Electrical device according to any of the preceding claims, **characterized in that** the first shielding part (7) and/or the second shielding part (9) has on its peripheral opening edge one or a plurality of contact lugs (17) which are bent in a manner directed away from the interior of the first and/or second shielding part (7, 9) into a plane approximately parallel to the plane of the carrier substrate (1) and which can be placed resiliently against the contact area or contact areas (5) of the carrier substrate (1).

10. Electrical device according to any of the preceding claims, **characterized in that** the contact lugs (17) are arranged in the regions between the spring arms (11, 12) and/or the sheet-metal arms (13).

11. Electrical device according to any of the preceding claims, **characterized in that** the contact lugs (17) are arranged opposite one another on the first surface (8) and the second surface (10) of the carrier substrate (1) and are electrically conductively connected to one another by means of plated-through holes (18) in the carrier substrate (1).

12. Electrical device according to either of Claims 10 and 11, **characterized in that** a plated-through hole (18) is arranged in the region of each contact lug (17).

13. Electrical device according to any of Claims 10 to 12, **characterized in that** the plated-through holes (18) are arranged at a small distance from one another.

14. Electrical device according to any of the preceding claims, **characterized in that** the carrier substrate is a multilayer printed circuit board.

15. Electrical device according to Claim 14, **characterized in that** one or two outer conductive levels of the multilayer printed circuit board form the contact areas and are connected to the fixed electrical potential.

16. Electrical device according to either of Claims 14 and 15, **characterized in that** one or a plurality of inner conductive levels of the multilayer printed circuit board are signal-carrying conductor tracks.

17. Electrical device according to any of the preceding claims, **characterized in that** a plurality of conductor track structures for connecting electronic components are arranged on the carrier substrate, wherein each conductor track structure is enclosed by an electrically conductive shielding element.

18. Electrical device according to Claim 17, **characterized in that** the conductor track structures are conductively connected to one another via an inner conductive level of the multilayer printed circuit board.

## Revendications

1. Dispositif électrique comportant un substrat support portant des composants électroniques, lequel substrat porte une structure de pistes conductrices destinées à relier les composants électroniques et sur lequel est placé un organe de blindage à conduction électrique qui enveloppe la structure de pistes conductrices et les composants, où l'organe de blindage se compose d'une première pièce de blindage en forme de pot appliquée par la bordure de son ouverture sur une première surface du substrat support et d'une deuxième pièce de blindage en forme de pot appliquée par la bordure de son ouverture sur une deuxième surface du substrat support et où les pièces de blindage peuvent être fixées sur le substrat support, où le substrat support comporte des deuxièmes évidements traversants à travers lesquels des premières branches de la première pièce de blindage et/ou des deuxièmes branches de la deuxième pièce de blindage traversent le substrat support et font, par leurs extrémités libres, saillie hors des deuxièmes évidements et mettent en contact électrique la deuxième pièce de blindage et /ou la première pièce de blindage, la première pièce de blindage étant reliée à un potentiel électrique fixe, ledit dispositif électrique étant **caractérisé par le fait que** la première pièce de blindage (7) en forme de pot est appliquée par la bordure de son ouverture sur une surface de contact (5), laquelle est reliée à un potentiel électrique fixe, de la première surface (8) du substrat support (1), que les pièces de blindage (7, 9) peuvent être fixées sur le substrat support (1) grâce à des appendices de fixation s'engageant dans des premiers évidements (6) du substrat support (1) et que les premières branches sont des premières branches de ressort (11), ainsi que les deuxièmes branches sont des deuxièmes branches de ressort (12).

2. Dispositif électrique selon la revendication 1, **caractérisé par le fait que** les premiers bras de ressort (11) de la première pièce de blindage (7) sont appliqués d'une façon élastique, par leur extrémité libre, sur la deuxième pièce de blindage (9) et/ou les deuxièmes bras de ressort (12) de la deuxième pièce de blindage (9) sont appliqués d'une façon élastique, par leur extrémité libre, sur la première pièce de blindage (7).

3. Dispositif électrique selon l'une des revendications précédentes, **caractérisé par le fait que** plusieurs premiers bras de ressort (11) et / ou plusieurs deuxièmes bras de ressort (12) sont disposés l'un à côté de l'autre avec un écartement correspondant à une largeur de bras de ressort.

4. Dispositif électrique selon l'une des revendications précédentes, **caractérisé par le fait que** les deuxièmes évidements sont des fentes (4, 4') à travers lesquelles plusieurs premiers bras de ressort (11) et / ou deuxièmes bras de ressort (12) font saillie l'un à côté de l'autre.

5. Dispositif électrique selon la revendication 4, **caractérisé par le fait que** des premiers et deuxièmes bras de ressort (11, 12) font saillie en alternance l'un à côté de l'autre à travers les fentes (4, 4').

6. Dispositif électrique selon l'une des revendications précédentes, **caractérisé par le fait que** les appendices de fixation sont des branches en tôle (13) faisant saillie à travers les premiers évidements (6) et dont les extrémités libres qui font saillie des premiers évidements (6) sont déformables.

7. Dispositif électrique selon la revendication 6, **caractérisé par le fait que** la première pièce de blindage (7) et/ou la deuxième pièce de blindage a, sur la bordure périphérique de son ouverture, dans un plan parallèle au plan du substrat support (1), des languettes (14) dotées d'ouvertures traversantes (15) et cintrées en les écartant de l'intérieur de la première pièce de blindage (7), lesdites languettes ayant environ la même section transversale que les branches en tôle (13) et grâce auxquelles les extrémités libres des branches en tôle (13) font saillie et sont déformables.

8. Dispositif électrique selon l'une des revendications précédentes, **caractérisé par le fait que** la première pièce de blindage et/ou la deuxième pièce de blindage (9) ont plusieurs épaulements d'appui (16), répartis sur la bordure périphérique de son ouverture, dans un plan approximativement parallèle au plan du substrat porteur (1), et cintrées en les écartant de l'intérieur de la première pièce de blindage et/ou de la deuxième pièce de blindage (9).

9. Dispositif électrique selon l'une des revendications précédentes, **caractérisé par le fait que** la première pièce de blindage (7) et/ou la deuxième pièce de blindage (9) ont, sur la bordure périphérique de son ouverture, une ou plusieurs languettes de contact (17) dans un plan approximativement parallèle au plan du substrat porteur (1), et cintrées en les écartant de l'intérieur de la première pièce de blindage et/ou de la deuxième pièce de blindage (7, 9) qui s'appliquent d'une façon élastique sur la ou les surfaces de contact (5) du substrat porteur (1).

10. Dispositif électrique selon l'une des revendications précédentes, **caractérisé par le f a i t** que les languettes de contact (17) sont placées dans les zones situées entre les branches de ressort (11, 12) et/ou les branches en tôle (13).

11. Dispositif électrique selon l'une des revendications précédentes, **caractérisé par le f a i t** que les languettes de contact (17) sont disposées, en se faisant réciproquement face, sur la première surface (8) et la deuxième surface (10) du substrat porteur (1) et sont reliées en conduction électrique les unes avec les autres grâce à des connexions traversantes (18) dans le substrat porteur (1).

12. Dispositif électrique selon l'une des revendications 10 et 11, **caractérisé par le fait qu'**une connexion traversante (18) est placée dans la zone de chaque languette de contact (17).

13. Dispositif électrique selon l'une des revendications 10 à 12, **caractérisé par le fait que** les connexions traversantes (18) sont disposées à une faible distance l'une de l'autre.

14. Dispositif électrique selon l'une des revendications précédentes, **caractérisé par le fait que** le substrat porteur est une carte multicouche à circuits imprimés.

15. Dispositif électrique selon la revendication 14, **caractérisé par le fait qu'**un ou deux plans extérieurs de conducteurs de la carte multicouche à circuits imprimés forment les surfaces de contact et sont reliés au potentiel électrique fixe.

16. Dispositif électrique selon l'une des revendications 14 et 15, **caractérisé p a r le fait** qu'un ou deux plans intérieurs de conducteurs de la carte multicouche à circuits imprimés sont des pistes conductrices transportant des signaux.

17. Dispositif électrique selon l'une des revendications précédentes, **caractérisé par le fait que**, sur le substrat porteur, sont disposées plusieurs structures à pistes conductrices pour le raccordement de composants électroniques, chaque structure à pistes conductrices étant enveloppée par un organe de blindage à conduction électrique.

18. Dispositif électrique selon la revendication 17, **caractérisé par le fait que** les structures à pistes conductrices sont reliées entre elles en conduction électrique par l'intermédiaire d'un plan intérieur de conducteurs de la carte multicouche à circuits imprimés.
